# EUROPÄISCHE PATENTSCHRIFT

(11) **EP 0 513 019 B1**
(45) Veröffentlichungstag und Bekanntmachung des Hinweises auf die Patenterteilung: **17.11.1994**
(21) Anmeldenummer: 91901690.7
(22) Anmeldetag: 16.01.1991
(51) Int. Cl.: G01C 21/08, G01C 17/30

(54) **VORRICHTUNG ZUR POSITIONSMESSUNG**
POSITION SENSOR
SYSTEME DE MESURE DE POSITION

(30) Priorität: 18.01.1990 DE 9000619 U
(43) Veröffentlichungstag der Anmeldung: 19.11.1992
(73) Patentinhaber: STEINER, Carl, D-95448 Bayreuth (DE)
(72) Erfinder: STEINER, Carl, D-95448 Bayreuth (DE)
(74) Vertreter: Voigt, Günter, Dipl.-Ing.
(86) Internationale Anmeldenummer: DE9100040
(87) Internationale Veröffentlichungsnummer: WO9110879

(56) Entgegenhaltungen:
- EP-A- 0 254 613
- DE-A- 3 012 241
- DE-A- 3 224 633
- DE-B- 1 773 303
- DE-C- 2 929 504
- GB-A- 2 186 694
- US-A- 4 546 550

## Beschreibung

Die Erfindung bezieht sich auf eine Vorrichtung gemäß Oberbegriff des Anspruchs 1.

Eine solche Vorrichtung ist grundsätzlich bereits aus der DE-AS 1 773 303 bekannt. Bei dieser bekannten Vorrichtung ist der Kern von einer gleichmäßig um diesen gewickelten Erregerspule umgeben, welche mittels einer periodischen Spannung bzw. eines periodischen Stroms derart angesteuert wird, daß der Kern weit genug in den Sättigungsbereich gesteuert wird. Die vier Empfangsspulen sind über den Umfang um jeweils 90 Grad versetzt angeordnet, wobei die einander diametral gegenüberliegenden Empfangsspulen gegeneinandergeschaltet sind. Durch Differenzbildung in den Empfangsspulenpaaren hebt sich in diesen grundsätzlich die transfomierte Spannung auf. Ein externes Magnetfeld, insbesondere die Horizontalkomponente des Erdmagnetfeldes, bewirkt jedoch eine Verschiebung des Arbeitspunktes auf der Magnetisierungskennlinie. Daraus resultiert eine Phasenverschiebung, die einen sich nicht aufhebenden Spannungsanteil verursacht. Dieser besteht im wesentlichen aus Harmonischen gerader Ordnung der Erregerfrequenz, wobei deren Amplituden dem externen Magnetfeld proportional sind. In der mit dem Empfangsspulen verbundenen Auswerteschaltung wird zweckmäßigerweise die zweite Harmonische ausgewertet, um ein der Richtung des externen Magnetfeldes entsprechendes Signal zu erzeugen. Diese Vorrichtung ist infolge von Inhomogenitäten und Unsymmetrien im Kern und in den Spulen für exaktere Messungen nicht geeignet. Sie weist außerdem eine Vielzahl von Bauelementen auf und ist daher recht aufwendig. Selbst bei einer Varianten mit einem in einem hermetisch abgeschlossenen Toroid schwimmenden ringförmigen Magnetkern wird der erwähnte Toroid auf einer recht aufwendigen Aufhängevorrichtung gelagert.

Aus der FR-OS 2 601 185 ist ein Magnetkern für einen Kompaß bekannt, bei dem die Empfängerspulen anders als bei der zuvor erwähnten DE-AS 1 773 303 nicht den Querschnitt des ringförmigen Magnetkerns umfassen, sondern den ringförmigen Magnetkern diametral umfassen.

Aus der DE-OS 3 012 241 ist eine weitere Vorrichtung zur Messung eines Magnetfeldes bekannt, bei der ein flüssigkeitsgelagerter Schwimmer zur Anwendung kommt, der über einen in einer horizontalen Ebene liegenden Lagerzapfen schwenkbar ist. Der Lagerzapfen ruht in einer umlaufenden Führungsnut, so daß der Schwimmer auch eine Drehbewegung ausführen kann. Eine feste Zuordnung des Schwimmers zu einer bestimmten Ausrichtung des Gehäuses ist damit nicht gewährleistet.

Der Erfindung liegt die Aufgabe zugrunde, eine Vorrichtung der eingangs erwähnten Art zu schaffen, die bei möglichst geringem Aufwand eine Messung von großer Zuverlässigkeit und Genauigkeit liefert.

Die Lösung dieser Aufgabe erfolgt durch die Merkmale des Anspruchs 1.

Vorteilhafte Weiterbildungen ergeben sich aus den Unteransprüchen.

Die Erfindung wird nachfolgend unter Bezugnahme auf die zeichnungsfiguren beispielsweise erläutert. Es zeigen:
- Fig. 1: eine Draufsicht auf die Vorrichtung zur Messung des Magnetfeldes,
- Fig. 2: einen Querschnitt durch die Vorrichtung gemäß Fig. 1 und
- Fig. 3: eine schematische Darstellung der Verknüpfung der einzelnen Teile der Vorrichtung untereinander.

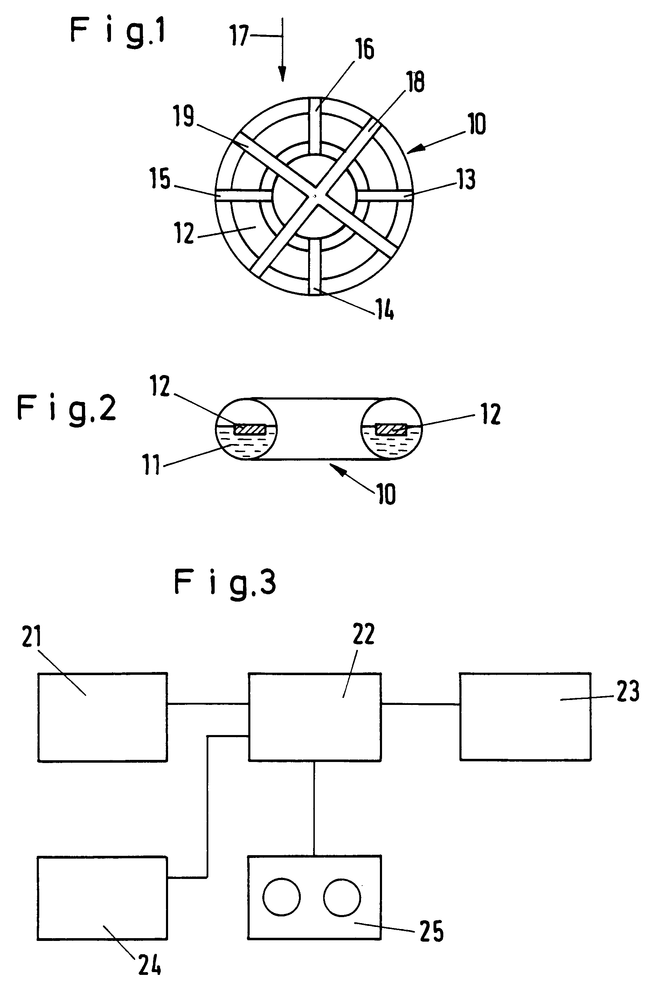

Der in Fig. 1 in der Draufsicht dargestellte, nach außen hermetisch abgeschlossene Toroid 10 wird in einem nicht dargestellten Fernglas so angeordnet, daß er mit seiner Hauptebene in etwa waagerecht liegt und ist in seinem Inneren teilweise mit einer möglichst niederviskosen Flüssigkeit 11 gefüllt. Die Füllung entspricht vorzugsweise dem halben Toroid-Volumen. Durch die geringe Viskosität der Flüssigkeit wird eine hohe Reaktionsgeschwindigkeit und eine geringe Neigung zur Blasenbildung gewährleistet. Auf der Flüssigkeit schwimmt ein ringförmiges Element 12 aus hochpermeablem Material, das auch mit einem Kunststoffmantel umgeben sein kann. Da der Toroid stets in einer im wesentlichen horizontalen Ebene gehalten wird und die Oberfläche der Flüssigkeit 11 sich selbsttätig horizontal ausrichtet, ist eine waagerechte Lage des ringförmigen Elements 12 sichergestellt. Dies ist Voraussetzung dafür, daß tatsächlich die horizontale Komponente des Erd-Magnetfeldes gemessen wird. Erregerspulen 13, 14, 15 und 16 umgeben den Querschnitt des Toroids 10. Sie sind jeweils um 90 Grad gegeneinander versetzt gleichmäßig über den Umfang des Toroids 10 verteilt angeordnet und elektrisch so hintereinandergeschaltet, daß sie im ringförmigen Element 12 ein in sich geschlossenes magnetisches Feld einheitlicher Richtung (beispielsweise im Uhrzeigersinn) erzeugen. Diesem so erzeugtem magnetischen Feld überlagert sich das externe magnetische Feld, das Erd-Magnetfeld, beispielsweise in Richtung des Pfeils 17 mit der Folge, daß im linken Teil des Toroids 10, d.h. im von der Erregerspule 15 umfaßten Querschnitt, sich erregtes Magnetfeld und Erd-Magnetfeld subtrahieren und im rechten Teil, d.h. im von der Erregerspule 13 umfaßten Querschnitt, sich erregtes Magnetfeld und Erd-Magnetfeld addieren. Daraus resultieren entsprechende transformierte Spannungen und Ströme in den Empfangsspulen 18 und 19, die den Toroid 10 diamentral umfassen.

Die Aussteuerung der Erregerspulen 13 bis 16 erfolgt bis in den Bereich der Sättigung. Durch Differenzbildung in den Empfangsspulen 18, 19 hebt sich die in diesen induzierte Spannung grundsätzlich auf. Das externe Magnetfeld, also in diesem Fall das Erd-Magnetfeld in Richtung des Pfeiles 17, bewirkt jedoch eine Verschiebung des Arbeitspunktes auf der Magnetisierungskennlinie. Dies wiederum hat eine Phasenverschiebung zur Folge, aus der sich ein nicht kompensierter Spannungsanteil ergibt mit im wesentlichen Harmonischen gerader Ordnung der Eigenfrequenz. Die Amplituden sind dem externen Magnetfeld, also dem Erd-Magnetfeld proportional.

Zur Auswertuung wird vorzugsweise die zweite Harmonische herangezogen, um ein der Richtung des externen Magnetfeldes entsprechendes Signal zu erzeugen.

Die Versatzwinkel der Erregerspulen 13 bis 16 und der Empfangsspulen 18 und 19 untereinander betragen bei der in den Figuren dargestellten Anzahl von vier Erregerspulen 13 bis 16 und zwei Empfangsspulen 18 und 19 untereinander jeweils 90 Grad. Die Spulen der einen Art sind gegenüber den Spulen der anderen Art um 45 Grad gegeneinander versetzt.

Bei abweichender Anzahl von Spulen ändern sich verständlicherweise auch die Winkel.

Das ringförmige Element 12 aus hochpermeablem Material wird bei Bedarf mit einem Kunststoffmantel umgeben, um die Schwimmfähigkeit des ringförmigen Elements 12 zu gewährleisten und das Gleiten auf der Innenwandung des Toroids 10 zu verbessern.

Bei einem Verdrehen des ringförmigen Elements 12 im Uhrzeiger- oder im Gegenuhrzeigersinn könnten Inhomogenitäten zu Verfälschungen des Meßergebnisses führen. Aus diesem Grunde wird das ringförmige Element 12 bei Bedarf gegen Verdrehung gesichert. Dies erfolgt über eine Führungsnut in der Ummantelung des ringförmigen Elements 12 und einen entsprechenden Vorsprung im Toroid 10 oder umgekehrt.

Die Meßergebnisse werden einer Auswerteeinrichtung zugeführt. Dies kann ein Mikroprozessor sein, der eine Vielzahl von Messungen in schneller zeitlicher Folge erlaubt. Dabei kann es sich entweder um eine Vielzahl von Messungen mit unterschiedlicher Zielrichtung des Fernglases oder aber auch um eine Vielzahl von Messungen mit gleicher Zielrichtung des Fernglases handeln. Bei Positionsmessungen vom schwankenden Objekt aus, beispielsweise von einen Land-, Luft- oder Wasserfahrzeug (z.B. bei Wellengang), kann dann mit Hilfe des Mikroprozessors aus der Vielzahl der Einzelmessungen ein Mittelwert - mit naturgemäß höherer Genauigkeit - gebildet und abgespeichert werden.

Die abgespeicherten Einzelmeßwerte oder gemittelten Meßwerte können zu gegebener Zeit aus ihren Speicherplätzen abgerufen und auf einem Display angezeigt werden. Damit entfällt die Notwendigkeit umständlicher handschriftlicher Notizen während der Positionsmessungen unter möglicherweise ungünstigen Wind- und Wetterverhältnissen.

Die gesamte Elektronik kann auf einer relativ kleinen Platine untergebracht werden, die oberhalb des üblichen Fernglasaufbaus angeordnet wird.

Konventionelle Peilferngläser benötigen beträchtliche Ausschwingzeiten bevor eine Messung durchgeführt werden kann. Mit der oben beschriebenen Vorrichtung verkürzen sich diese Zeiten ganz erheblich.

Für die Peilung wird das Fernglas mit einer an sich bekannten Strichplatte versehen.

Deklinationsfehler werden durch entsprechende Programmierung softwaremäßig kompensiert, und zwar durch Eingabe eines dem jeweiligen Standpunkt auf der Erde entsprechenden Korrekturwerts, der einschlägigen Karten entnommen werden kann.

Zum Setzen der Deklination wird eine Taste gedrückt. Bei beispielsweise 10 Grad östlicher Deklination dreht sich der Peilende bei gedrückter Taste so weit nach rechts bis er die Anzeige 10 abliest. Bei zum Beispiel 20 Grad westlicher Deklination dreht er sich bei gedrückter Taste so weit nach links bis die Anzeige 340 Grad (360 - 20 Grad) erscheint. Anschließend gibt er die Taste wieder frei. Der jeweils abgespeicherte Deklinationswert wird auf einem speziellen Speicherplatz abgespeichert und kann als solcher auf Wunsch angezeigt werden.

Zum Ausgleich der Inklinationsfehler werden bisher unterschiedlich ausbalancierte Fluidkapseln verwendet. Für den Anwender bedeutet dies, daß er zur Benutzung des Fernglases in einer anderen Zone der Erde auch eine andere Fluidkapsel benötigt. Diesen Austausch kann normalerweise nur der Hersteller durchführen. Im zuvor beschriebenen elektronischen System treten Inklinationsfehler nicht auf.

Das Peilfernglas wird mit handelsüblichen Batterien betrieben. Um die Energiequellen nicht unnötig in Anspruch zu nehmen, schaltet sich das Gerät nach einer vorgegebenen Zeit der Nichtbenutzung selbttätig aus.

Etwaige Fehler im System und unzureichender Ladezustand der Batterien können jeweils während der Einschaltphase angezeigt werden.

Die gemessenen bzw. abgespeicherten und abgerufenen Werte werden bei Bedarf über ein LED-Display 23 (Fig. 3) angezeigt und in den Strahlengang des Fernglases eingespiegelt. Ggfs. kann das LED-Diplay auch direkt im Strahlengang des Fernglases eingebaut werden. Die Leuchtstärke kann nach der Helligkeit der Umgebung, d.h. nach dem durch das Objektiv einfallenden Licht, gesteuert werden, um unerwünschte Blendeffekte in der Nacht bzw. in der Dämmerung zu vermeiden.

In Fig. 3 werden die funktionellen Verknüpfungen der einzelnen Teile der Vorrichtung schematisch dargestellt. Vom Magnetfeldsensor 21 werden die gemessenen Werte an einen Mikrocomputer 22 weitergeleitet und verarbeitet sowie ggfs. korrigiert (Kompensation von Deklinations- und Inklinations-Fehlern u.ä.). Die unkorrigierten bzw. korrigierten Werte sowie die etwaigen Vorgaben im Rechnerprogramm können auf dem erwähnten LED-Display 23 angezeigt werden. Diese Anzeige wird in den Strahlengang des Fernglases eingespiegelt, sofern das LED-Display 23 nicht direkt im Strahlengang des Fernglases angeordnet ist. Die jeweils gewünschten Funktionen des Mikrocomputers werden von einem Tastenfeld 25 aus gesteuert.

## Patentansprüche

1. Vorrichtung zur Ermittlung der jeweiligen Position auf der Erde über die Messung des Erdmagnetfeldes, bestehend aus einer Magnetfeldsonde mit einem in einer horizontalen Ebene gehaltenen ringförmigen Element aus hochpermeablem Material, Erregerspulen und zugehörigen Empfängerspulen, wobei das ringförmige Element (12) aus hochpermeablem Material schwimmend in einem hermetisch abgeschlossenen Toroid (10) angeordnet ist, die Erregerspulen (13 bis 16) um jeweils einen ersten Winkel gegeneinander versetzt gleichmäßig über den Umfang des Toroids (10) verteilt sind und den Querschnitt des Toroids (10) umfassen und die Empfängerspulen (18, 19) um jeweils einen zweiten Winkel gegeneinander versetzt gleichmäßig über den Umfang des Toroids (10) verteilt sind, dadurch gekennzeichnet, daß die Empfängerspulen den Toroid (10), der etwa zur Hälfte mit einer Flüssigkeit gefüllt ist, diametral umfassen sowie daß das ringförmige Element (12) gegen Verdrehung gesichert ist.

2. Vorrichtung nach Anspruch 1, dadurch gekennzeichnet, daß der Toroid (10) einen kreisförmigen Querschnitt aufweist.

3. Vorrichtung nach einem der Ansprüche 1 oder 2, dadurch gekennzeichnet, daß es sich bei der Flüssigkeit (11) im Toroid (10) um eine niederviskose Flüssigkeit handelt.

4. Vorrichtung nach einem der Ansprüche 1 bis 3, dadurch gekennzeichnet, daß das ringförmige Element (12) aus hochpermeablem Material mit einem Kunststoffmantel umgeben ist.

5. Vorrichtung nach Anspruch 4, dadurch gekennzeichnet, daß der Kunststoffmantel mit einer Führungsnut zur Sicherung des ringförmigen Elements (12) gegen Verdrehung versehen ist.

6. Vorrichtung nach einem der Ansprüche 1 bis 5, dadurch gekennzeichnet, daß die Empfängerspulen (18, 19) mit einer Meß- und einer Auswerteschaltung verbunden sind.

7. Vorrichtung nach Anspruch 6, dadurch gekennzeichnet, daß die Auswerteschaltung mit einem Meßwerte-Speicher verbunden ist.

8. Vorrichtung nach Anspruch 7, dadurch gekennzeichnet, daß die Auswerteschaltung mit einem Zusatz zur Kompensation von Deklinations- und Inklinationsfehlern versehen ist.

9. Vorrichtung nach einem der Ansprüche 1 bis 8, dadurch gekennzeichnet, daß die Auswerteschaltung mit einem Zusatz zur Mittelwert-Bildung aus einer Vielzahl in kurzer zeitlicher Folge erfaßter Meßwerte versehen ist.

## Claims

1. Device for ascertaining of the respective position on the earth by way of measurement of the earth magnetic field, consisting of a magnetic field probe with an annular element of highly permeable material held in a horizontal plane, exciter coils and associated receiver coils, wherein the annular element (12) of highly permeable material is arranged to be floating in a hermetically sealed toroid (10), the exciter coils (13 to 16) are uniformly distributed around the circumference of the toroid (10) displaced relative to one another by a first angle and embrace the cross-section of the toroid (10), and the receiver coils (18, 19) are uniformly distributed around the circumference of the toroid (10) displaced relative to one another by a second angle, characterised thereby that the receiver coils diametrally embrace the toroid (10), which is filled to about halfway with a liquid, and that the annular element (12) is secured against rotation.

2. Device according to claim 1, characterised thereby that the toroid (10) has a circular cross-section.

3. Device according to one of claims 1 or 2, characterised thereby that a low viscosity liquid is concerned in the case of the liquid (11) in the toroid (10).

4. Device according to one of claims 1 to 3, characterised thereby that the annular element (12) of highly permeable material is enclosed by a plastics material casing.

5. Device according to claim 4, characterised thereby that the plastics material casing is provided with a guide groove for the securing of the annular element (12) against rotation.

6. Device according to one of claims 1 to 5, characterised thereby that the receiver coils (18, 19) are connected with a measuring and evaluating circuit.

7. Device according to claim 6, characterised thereby that the evaluating circuit is connected with a measurement values storage device.

8. Device according to claim 7, characterised thereby that the evaluating circuit is provided with an auxiliary device for compensation for declination and inclination errors.

9. Device according to one of claims 1 to 9, characterised thereby that the evaluating circuit is provided with an auxiliary device for mean value formation from a plurality of measurement values detected in short time sequence.

## Revendications

1. Dispositif pour déterminer la position sur terre par mesurage du champ magnétique de la terre, qui est constitué d'une sonde du champ magnétique pourvue d'un corps annulaire en matériau très perméable maintenu dans un plan horizontal, de bobines excitatrices et de bobines réceptrices correspondantes, où l'élément annulaire (12) en matériau très perméable flotte dans un toroïde (10) fermé hermétiquement, où les bobines excitatrices (13) à (16) sont réparties régulièrement sur la circonférence du toroïde en étant décalées d'un premier angle l'une par rapport à l'autre et en entourant la section transversale dudit toroïde, et, où les bobines réceptrices (18), (19) sont réparties régulièrement sur la circonférence du toroïde en étant décalées d'un second angle l'une par rapport à l'autre, *caractérisé en ce que* les bobines réceptrices entourent diamétralement le toroïde rempli à peu près à moitié d'un liquide (11) et *en ce que* l'élément annulaire est garanti contre tout risque de torsion.

2. Dispositif selon la revendication 1 *caractérisé en ce que* le toroïde (10) présente une section transversale circulaire.

3. Dispositif selon l'une des revendications 1 ou 2 *caractérisé en ce que* le liquide (11) contenu dans le toroïde (10) présente une faible viscosité.

4. Dispositif selon l'une des revendications 1 à 3 *caractérisé en ce que* l'élément annulaire (12) en matériau très perméable est entouré d'une enveloppe en matière synthétique.

5. Dispositif selon la revendication 4 *caractérisé en ce que* l'enveloppe en matière synthétique comporte une rainure de guidage permettant de garantir l'élément annulaire (12) contre tout risque de torsion.

6. Dispositif selon l'une des revendications 1 à 5 *caractérisé en ce que* les bobines réceptrices (18), (19) sont reliées à un circuit de mesure et à un circuit d'évaluation.

7. Dispositif selon la revendication 6 *caractérisé en ce que* le circuit d'évaluation est relié à une mémoire de stockage des valeurs mesurées.

8. Dispositif selon la revendication 7 *caractérisé en ce que* le circuit d'évaluation comporte un élément complémentaire pour compenser les erreurs de déclinaison et d'inclinaison.

9. Dispositif selon l'une des revendications 1 à 8 *caractérisé en ce que* le circuit d'évaluation comporte un élément complémentaire pour établir la valeur moyenne à partir d'une multitude de valeurs mesurées à de courts intervalles.
